Europäisches Patentamt

European Patent Office

Office européen des brevets

(19)

(11) **EP 0 471 968 B1**

(12) **EUROPÄISCHE PATENTSCHRIFT**

(45) Veröffentlichungstag und Bekanntmachung des Hinweises auf die Patenterteilung:
**12.03.1997 Patentblatt 1997/11**

(51) Int Cl.6: **H04J 1/05**

(21) Anmeldenummer: **91111386.8**

(22) Anmeldetag: **09.07.1991**

(54) **Verfahren zur Aufbereitung eines digitalen Frequenzmultiplexsignals sowie dessen Zerlegung**

Method of processing a digital frequency multiplexed signal and for decomposing it

Procédé de traitement d'un signal multiplexé en fréquence et sa décomposition

(84) Benannte Vertragsstaaten:
**AT CH DE DK FR GB LI**

(30) Priorität: **22.08.1990 DE 4026477**

(43) Veröffentlichungstag der Anmeldung:
**26.02.1992 Patentblatt 1992/09**

(73) Patentinhaber: **ROBERT BOSCH GMBH**
**70442 Stuttgart (DE)**

(72) Erfinder: **Göckler, Heinz Dr.-Ing.**
**W-7150 Backnang (DE)**

(56) Entgegenhaltungen:
**DE-C- 3 716 018**

- **IEEE TRANSACTIONS ON COMMUNICATIONS Bd. 30, Nr. 7, Juli 1982, NEW YORK US Seiten 1623 - 1628 DEL RE ET AL. 'An Analytic Signal Approach for Transmultiplexers : Theory and Design'**
- **Proceedings of the IEEE, Bd. 69, Nr. 11, November 1981, New York, US; Seiten 1419 - 1450 SCHEUERMANN ET AL. 'A Comprehensive Survey of Digital Transmultiplexing Methods'**
- **IEEE TRANSACTIONS ON COMMUNICATIONS Bd. 22, Nr. 9, September 1974, NEW YORK US Seiten 1199 - 1205 BELLANGER ET AL. 'TDM - FDM Transmultiplexer : Digital Polyphase and FFT'**

**Beschreibung**

Die Erfindung geht aus von einem Verfahren zur Aufbereitung eines digitalen Frequenzmultiplexsignals aus Kanalsignalen, z. B. Fernsehkanälen gemäß dem Oberbegriff des Patentanspruchs 1. Ein solches Verfahren ist bekannt aus der DE 37 16 018 C1[2]

Von den digitalen Frequenzmultiplex-Signalaufbereitungsverfahren mit Einzelkanalumsetzung stellen die Verfahren gemaß [1] und die Weiterentwicklung gemäß [2] aufwandsgünstige Realisierung dar, die auf der Verarbeitung von komplexwertigen Signalen mit digitalen Filtern mit komplexwertigen Koeffizienten beruhen. Obwohl das Verfahren gemäß [2] zu aufwandgünstigeren Realisierungen führt wie das Verfahren gemäß [1], ist das Verfahren gemäß [2] für Kabelfernseh (CATV)-Systeme mit extrem hohen Ausgangsabtastfrequenzen ungeeignet, weil die Abtastfrequenz vom Eingang zum Ausgang stufenweise hochgesetzt wird und so Zwischenwerte der Abtastfrequenzen auftreten, die mit digitalen Filtern basierend auf herkömmlichen Technologien nicht oder nur mit großem Schaltungs- und/oder Leistungsaufwand handhabbar sind.

Der Erfindung liegt die Aufgabe zugrunde, ein Verfahren zur Aufbereitung eines digitalen Frequenzmultiplexsignals aus Kanalsignalen anzugeben, welches trotz hoher Abtastraten einfach und aufwandsarm realisierbar ist. Außerdem soll ein Verfahren zur Zerlegung von digitalen Frequenzmultiplexsignalen angegeben werden. Diese Aufgabe wird bezüglich der Aufbereitung durch die Schritte des Anspruchs 1 und bezüglich der Zerlegung durch die Schritte des Anspruchs 14 gelöst. Die Unteransprüche zeigen vorteilhafte Ausgestaltungen der Aufbereitung bzw. der Zerlegung auf.

Die Erfindung weist gegenüber bekannten Realisierungskonzepten folgende Vorteile auf:
Für die Filterung nach der Digitalisierung der Kanalsignale ist nur ein Filtertyp notwendig wohingegen das Konzept gemäß [1] zwei verschiedene Filtertypen - einen für gerade und einen für ungerade Kanalnummern - erfordert. Der Vorteil der Einzelkanalumsetzung liegt darin, daß die einzelnen Kanäle unabhängig voneinander zuverlässig und flexibel verarbeitet werden.

Führt man die Kanalsignale gemäß dem Schritt nach Anspruch 4 zu, so kann das Filter am Ausgang des A/D-Umsetzers einfach aufgebaut werden, z.B. als komplexes Halbbandfilter gemäß [3].

Mit der Wahl der Umsetzerfrequenz gemäß Anspruch 3 läßt sich ein flexibles System realisieren, d.h. bei unveränderten Abtastfrequenzen lassen sich veränderte Kanalraster mit anderen Bandbreiten realisieren.

Durch Anwendung der Schritte gemäß den Ansprüchen 6 und/oder 8 lassen sich FIR-Filter mit reellen Koeffizienten realisieren, bei denen einige Koeffizienten 0 sind, wenn entsprechende Dämpfungserfordernisse dies zulassen, die bei der Aufbereitung von TV-Kanalsignalen unter anderem erfüllt sind. Solche FIR-Filter sind aus [4] an sich bekannt. Diese Filter werden als L-Band-Filter bezeichnet, wobei die ganze Zahl L angibt, um wieviel die Abtastfrequenz im Falle der Aufbereitung des Frequenzmultiplexsignals erhöht (im Falle der Zerlegung erniedrigt) wird. L-1 gibt auch die Zahl der Sperrbereiche des L-Band-Filters im Intervall [0, $f_A$], mit $f_A$ = Abtastfrequenz, an.

Durch die Verwendung eines geeigneten komplexen Polyphasen-Netzwerkes lassen sich alle Operationen der Filter $H_i$ aus [1], die auch L-Band-Filter sein können, bei der niedrigen noch handhabbaren Abtastrate $f_A$ durchführen. Das komplexe Polyphasen-Netzwerk besteht hierbei aus L komplexen Zweigfiltern, deren Ausgangsfolgen durch einen Multiplexer, der allein mit der hohen Abtastrate $f_A \cdot L$ betrieben werden muß, zu einem Frequenzmultiplex-Gesamtsignal ineinander verschachtelt werden.

Die Summation der Einzelkanalsignale, die eigentlich bei der hohen Rate $f_A \cdot L$ vorzunehmen wäre, kann durch die Vorgehensweise nach den Schritten des Anspruchs 10 vorteilhaft in die niederratigen Zweigfilter des komplexen Polyphasen-Netzwerkes hineingezogen werden.

Mit den Maßnahmen nach Anspruch 12 gelingt es für alle Kanäle mit nur je einem Satz Verzögerungsglieder für Real- und Imaginärteil der Signale, entsprechend einem Polyphasen-Netzwerk, auszukommen.

Alle für die Frequenzmultiplexbildung aufgezeigten Realisierungsmöglichkeiten lassen sich durch die Hermite'sche Transposition gemäß [5] für die Zerlegung eines Frequenzmultiplexsignals mittels eines Frequenzdemultiplexers einsetzen.

Anhand der Zeichnungen werden einige Ausführungsbeispiele der Erfindung näher erläutert.
Es zeigen

Figur 1        ein Ausführungsbeispiel für eine Frequenzmultiplexbildung,
Figur 2        die spektrale Darstellung bei der Aufbereitung der Frequenzmultiplexsingale,
Figur 3        ein TV-Signal mit auf den Bildträger BT bezogenen relativen Frequenzangaben,
Figur 4        eine Filterstruktur für ein digitales Kanalfilter am Ausgang des A/D-Wandlers,
Figur 5        den Dämpfungsverlauf eines Kanalfilters hinter dem A/D-Wandler,
Figur 6        den Dämpfungsverlauf eines Bandfilters,
Figur 7        eine Prinzipdarstellung einer Filterstruktur mit komplexen Koeffizienten,
Figur 8        ein Polyphasen-Netzwerk mit N = 24 Koeffizienten ungleich 0,

Figur 9        ein Polyphasen-Netzwerk mit vorgezogener Addition und nur einem Multiplexer,

Figur 10       ein Filterzweig des Polyphasen-Netzwerkes in transponierter Struktur,

Figur 11       ein Polyphasen-Netzwerk mit minimaler Anzahl von Verzögerungsgliedern,

Figur 12       eine zweite Variante zur Multiplexbildung,

Figur 13       die spektrale Darstellung der Aufbereitung der Frequenzmultiplex-Signale gemäß der zweiten Variante.

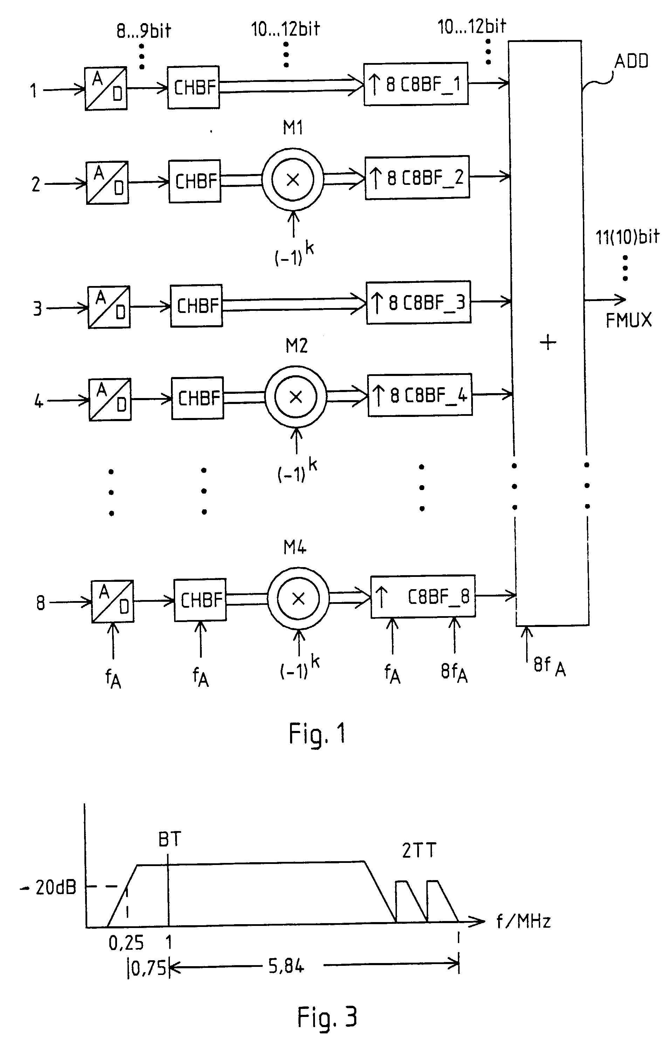

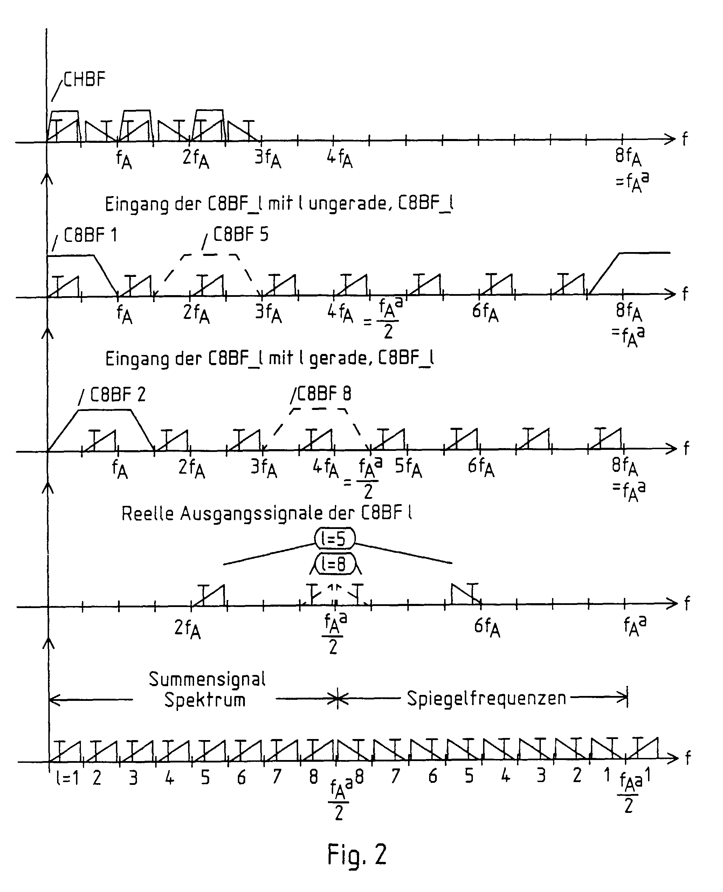

Figur 1 zeigt ein Blockschaltbild einer Frequenzmultiplexbildung nach der Erfindung gemäß einer ersten Variante. Die Kanalsignale, z.B. 1.. 8, die zu einem digitalen Frequenzmultiplexsignal FMUX zusammengefügt werden, werden über die Eingänge 1 bis 8 jeweils einem A/D-Wandler zugeführt. Die Ausgangssignale der A/D-Wandler werden über für alle 8 Kanäle identische digitale Kanalfilter CHBF geführt. Die Abtastfrequenz der A/D-Wandler und der digitalen Kanalfilter CHBF beträgt im Ausführungsbeispiel $f_A$ = 14 MHz. Diese Abtastfrequenz $f_A$ = 14 MHz ergibt sich aus dem 7 MHz Kanalraster für TV-Signale. Die Ausgangssignale der Kanalfilter CHBF werden bezüglich der Kanäle mit geraden Nummern um $f_A/2$ in der Frequenz verschoben und zwar mittels der Modulatoren M1 bis M4. Diese Frequenzverschiebung wird vorgenommen, um zu erreichen, daß sich benachbarte Kanäle bezüglich ihrer Spektren in resultierenden Frequenzmultiplexsignal nicht überlappen. Die spektrale Lage der Kanäle ist aus der ersten Zeile der Figur 2 zu entnehmen. Diese erste Zeile zeigt die Kanalsignale mit darüber gezeichneter Filterkennlinie des Kanalfilters CHBF. Sowohl die frequenzverschobenen als auch die nicht frequenzverschobenen mittels der Kanalfilter CHBF gefilterten Kanalsignale werden kanalindividuellen Bandfiltern CnBFl mit komplexen Koeffizienten zugeführt, hier im Ausführungsbeispiel 8-Bandfiltern C8BFl. Der Index l = 1...8 bezeichnet das jeweilige individuelle Bandfilter C8BF1....C8BF8. Eingangsseitig arbeiten diese Bandfilter mit der niedrigen Abtastrate $f_A$, wohingegen ausgangsseitig die Abtastrate um den L erhöht ist. Im Ausführungsbeispiel wurde L = 8 gewählt. Demnach ist die ausgangsseitige Abtastrate $f_A{}^a$ = 8 $f_A$ = 112 MHz.

Die zweite und dritte Zeile in Figur 2 zeigt die Lage der mittels den Filtern CHBF ausgefilterten Kanalsignale wie sie an den Eingängen der kanalindividuellen Bandfilter C8BFl vorliegen. Darüber gezeichnet sind die Filterkennlinien der Filter C8BFl. Die zweite Zeile gilt für ungerade Kanalnummern l = 1, 3, 5, 7. Eingezeichnet ist die Filterkennlinie für l = 1 (durchgezogen) und für l = 5 (gestrichelt). Die dritte Zeile gilt für gerade Kanalnummern l = 2, 4, 6, 8. Eingezeichnet ist die Filterkennlinie für l = 2 (durchgezogen) und l = 8 (gestrichelt). Für die Weiterverarbeitung werden nur die reellen Ausgangssignale der C8BFl Bandfilter benötigt, daher sind in der vierten Zeile von Figur 2 nur die reellen Ausgangssignale der C8BFl Bandfilter dargestellt und zwar beispielhaft für den Fall l = 5 und l = 8 gestrichelt. Die Ausgangssignale aller C8BFl Bandfilter werden digital addiert. Hinter der in Figur 1 dargestellten Addierstufe ADD ist das Frequenzmultiplexsignal FMUX beispielsweise für Übertragungszwecke über Lichtwellenleiter verfügbar. Die Addierstufe ADD ist, wie später noch im einzelnen erläutert wird, in die C8BFl-Filter hereingezogen, sodaß die Ausgangssignale der Bandfilter C8BFl nur noch mittels eines Multiplexers ineinander verschachtelt werden müssen. Das Spektrum des Summensignals, d.h. die reellen Signale am Eingang des Multiplexers, ist in der letzten Zeile von Figur 2 dargestellt mitsamt den Spiegelfrequenzen.

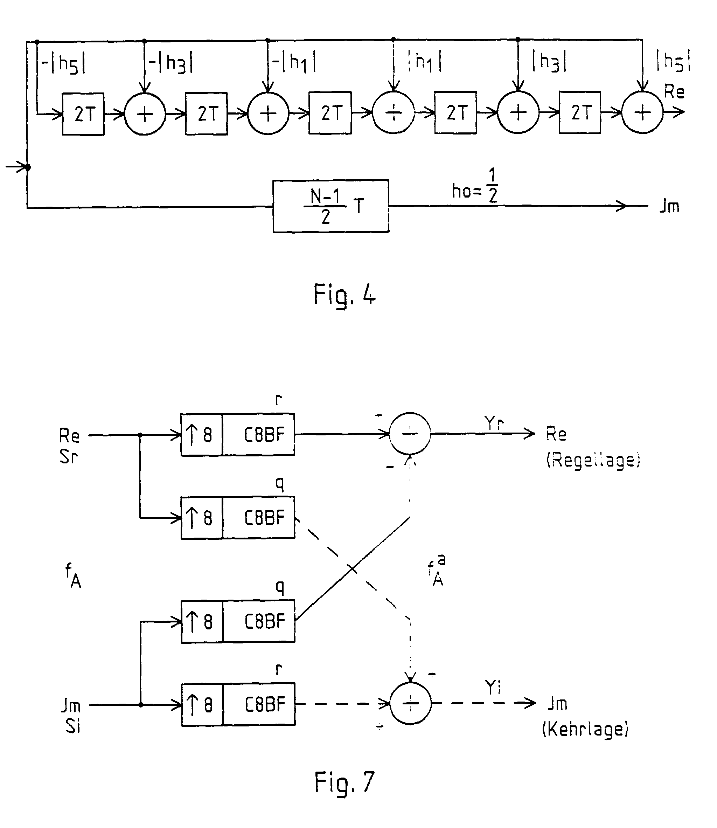

Um Probleme auf der Empfangsseite, insbesondere hinsichtlich Analogfilterung und Mischung, zu vermeiden bzw. so klein wie möglich zu halten, wird der Bildträger BT (Figur 3) des TV-FDM-Signals möglichst 1 MHz oder geringfügig weniger oberhalb der Kanalrasterfrequenzen gelegt (Regellage). Als Ripple-Bandbreite für die gleich aufgebauten Filter CHBF am Ausgang der A/D-Wandler wurde deshalb gemäß Figur 3 (5,84 + 0,75) MHz ≈ 6,6 MHz angesetzt. Da für eine aufwandsgünstige Filterrealisierung diese Bandbreite symmetrisch zu $f_A/4$ = 3,5 MHz liegen muß, ist das gemäß Figur 3 im Bereich [0,25, 6,84] MHz liegende TV-Spektrum um 0,045 MHz zu tieferen Frequenzen hin verschoben am A/D-Wandler anzuliefern. Der Bildträger BT liegt dann bei 955 kHz (rel.). Diese Überlegung führt zu einem CHBF-Filter mit N = 95 Koeffizienten bei einer Abtastfrequenz von $f_A$ = 14 MHz. Der Durchlaßbereich DB beträgt 3,5 ± 3,3 MHz. Die Sperrdämpfung beträgt $a_{sp}$ > 48,5 dB bei einer Wortbreite $w_c$ > 12 bit und die Rippledämpfung im Durchlaßbereich ist ≤ 0,1 dB (Spitze-Spitze).

Die Filterstruktur kann aus der Beziehung:

$$H(z) = \sum_{i=-\frac{N-1}{2}}^{\frac{N-1}{2}} c_i\, z^{-i}$$

abgeleitet werden. Hierin bedeuten:

$H(z) =$ komplexe Filterübertragungsfunktion,

$N =$ Zahl der komplexen Koeffizienten bzw. Länge der Impulsantwort,

$\underline{c}_i =$ die komplexwertige Impulsantwort bzw. die Koeffizienten des Filters,

$z =$ $e^{\,j2\pi f/f_A\,a}$

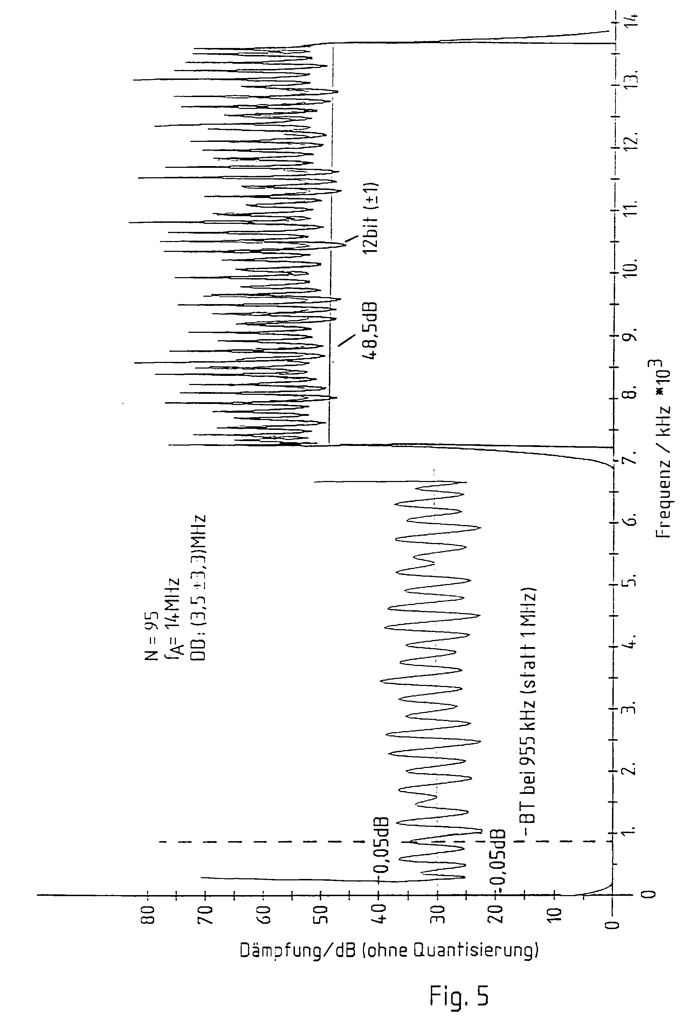

Figur 4 zeigt als Beispiel eine solche Filterstruktur, bei der die Koeffizienten $c_i$ entweder rein reel oder rein imaginär sind entsprechend [3], für $N = 11$ als kausale Realisierung und Figur 5 zeigt den Dämpfungsverlauf eines entsprechenden Filters mit $N = 95$ über der Frequenz.

Die in Figur 4 dargestellten Koeffizientenwerte $h_i$ sind die des zugehörigen Prototyptiefpaßfilters. Zur Realisierung der kanalindividuellen Bandfilter C8BFI können beispielsweise Prototyptiefpaßfilter (8-Bandfilter) mit folgenden Daten verwendet werden:

Durchlaßbereich: $f_d = 3{,}3$ MHz,

Abtastfrequenz: $f_A^{\,a} = 112$ MHz.

Sperrbereiche:

$$f_{sp} = m \cdot \frac{f_A^{\,a}}{8} \pm 3{,}3 \text{ MHz,}$$

$m = 1,2,....,7$

Sperrdämpfung: $a_s \geq 48{,}5$ dB.

Ein Filterkonzept mit $N = 35$ reellen Koeffizienten erfüllt diese Forderungen.

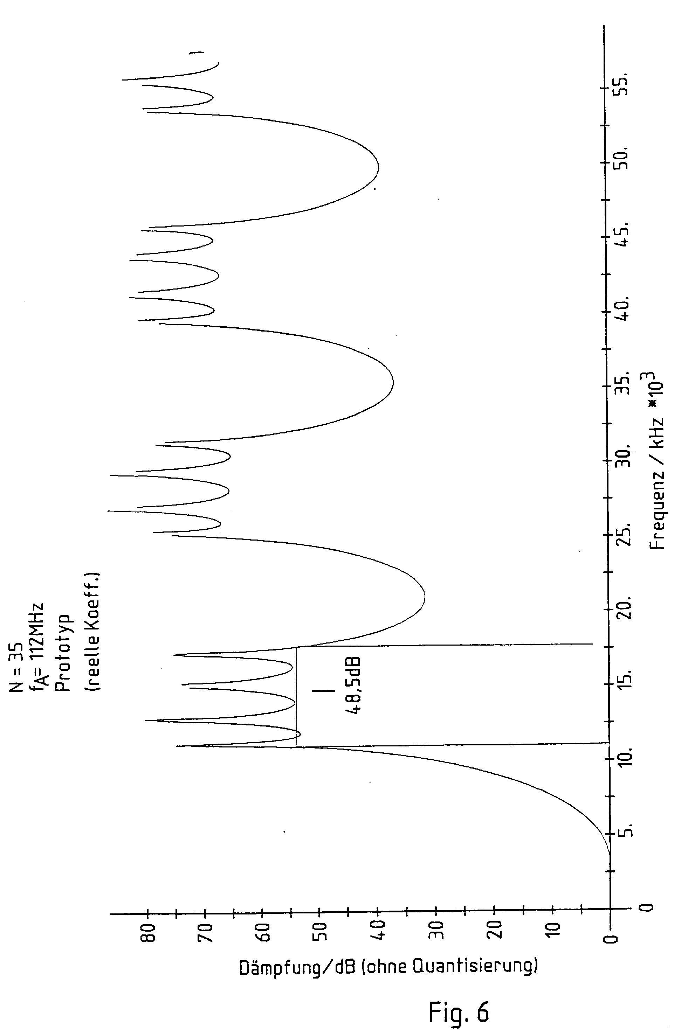

Figur 6 zeigt beispielhafte den Dämpfungsverlauf eines solchen Bandfilters über der Frequenz.

Als Filterstrukturen dieser kanalindividuellen Bandfilter eignen sich insbesondere Polyphasenstrukturen, bei denen alle Operationen mit Ausnahme der Verschachtelung der Teilausgangsfolgen bei der niedrigen Eingangsabtastfrequenz $f_A = 14$ MHz durchgeführt werden können.

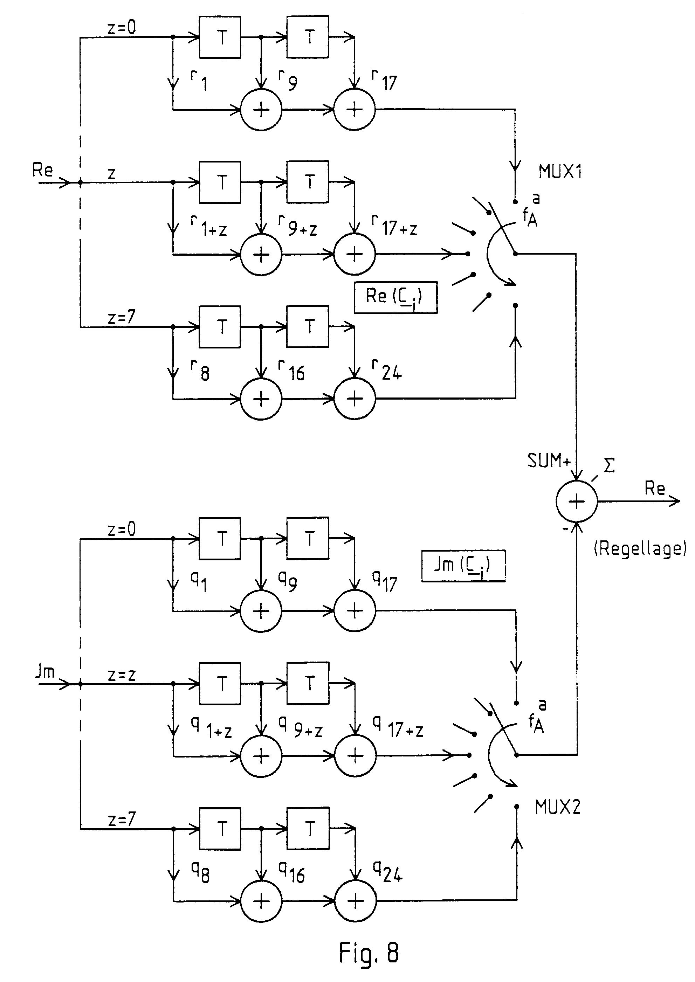

Figur 7 zeigt eine Prinzipdarstellung eines Filters mit komplexen Koeffizienten für die Verarbeitung komplexer Signale als Ausgangsbasis für die Beschreibung einer solchen Polyphasen-Filterstruktur. Das Eingangssignal $\underline{s} = s_r + j s_i$ eines solchen Filters ist komplex, vom Ausgangssignal wird für diesen Anwendungsfall nur der Realteil Re (Regellage) benötigt. Daher ist nur der Gesamtaufwand entsprechend zwei reellen Bandfiltern C8BF nötig. Allgemein gilt mit den komplexen Teilfilterimpulsanworten $\underline{c} = r + jq$ für das Ausgangssignal:

$$y_r + jy_i = r * s_r - q * s_i + j(q * s_r + r * s_i).$$

Das Symbol ($*$) bedeutet "Faltung" und

$$\underline{c} = \left\{ \underline{c}_i \,\middle|\, i = \frac{N-1}{2} \;\cdots\; \frac{N-1}{2} \right\} \,.$$

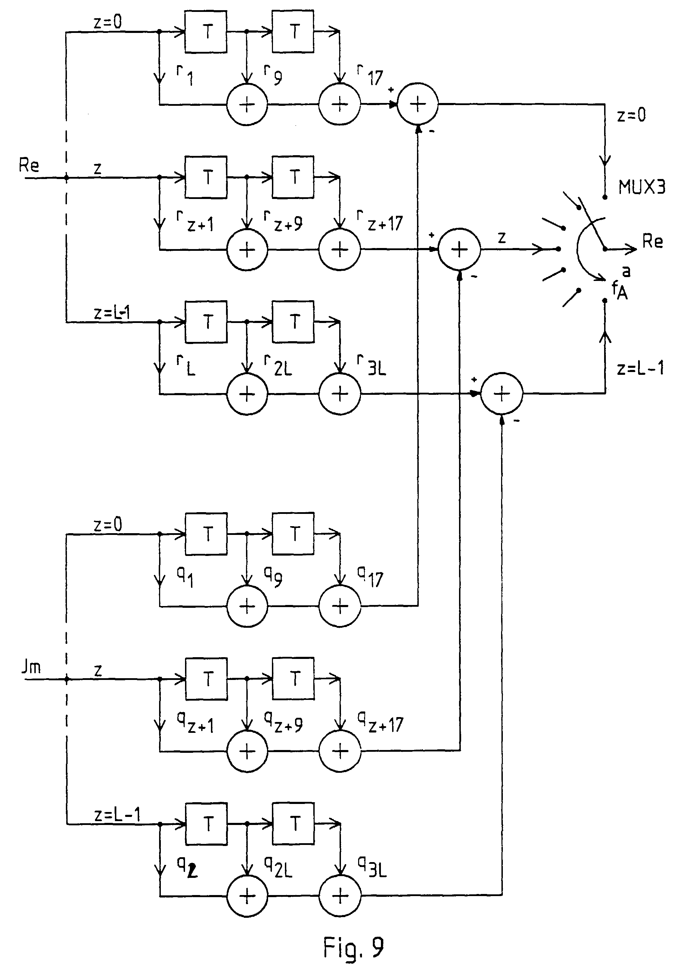

Nachfolgend wird ein Polyphasen-Netzwerk (PPN) vorgestellt mit $N = 24$ Koeffizienten ungleich 0 (Figur 8 und 9).

Die beiden Ausgangsmultiplexer/Schalter MUX1 und MUX2 (Figur 8) zur Verschachtelung der Zweigausgangsfolgen laufen streng synchron. Der ausgangsseitige Addierer SUM kann daher über die Multiplexer in die einzelnen der z Zweige hineingezogen werden, weshalb nur noch ein Multiplexer/Schalter MUX3 erforderlich ist und statt einer schnellen Addition bzw. Differenzbildung $L = 8$ langsame Additionen ausgeführt werden können. Diese erfindungsgemäße vorteilhafte Ausbildung des Polyphasen-Netzwerkes ist in Figur 9 dargestellt.

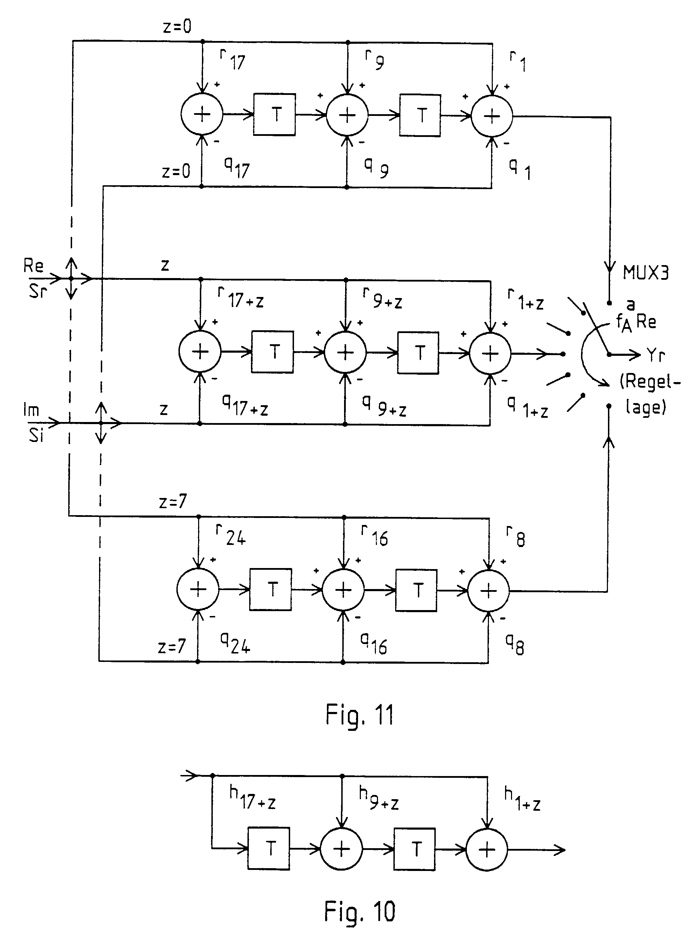

Für die Ausgestaltung der einzelnen Zweigfilter des Polyphasen-Netzwerkes PPN gemäß Figur 8 kann jeweils die transponierte Struktur verwendet werden (Figur 10). Zwischen jeweils zwei Teiladdierern ist ein Verzögerungsglied T angeordnet. Von der Struktur des Polyphasen-Netzwerkes gemäß Figur 9 gelangt man zu der Struktur gemäß Figur 11, wenn man die Zweigfilter in Figur 9 durch die Struktur nach Figur 10 ersetzt, und die r- und q- Zweigfilter des Zweigs z jeweils zu einer Struktur zusammenfaßt mit gemeinsamen Verzögerungsgliedern. In Figur 10 steht $h_i$ für die Koeffizienten $r_i$ und $q_i$. Die Struktur gemäß Figur 11 ist im Gegensatz zu Figur 9 kanonisch bezüglich der Zahl der Verzögerungsglieder (minimale Zahl von Verzögerungsgliedern).

Wie Figur 11 weiter zeigt, werden die einzelnen Multiplikationen in den Zweigen mit den Koeffizienten

$$q_{L \cdot M + z + 1} \text{ und } r_{L \cdot M + z + 1}$$

wobei M = 0, 1, 2,......und z = 0....L-1 ist,

vorgenommen. Für den Realteil $y_{rz}$ werden die Teil-Produktpaare mit jeweils gleichen Indizes, z.B. $r_{17+z}$ und $q_{17+z}$ addiert, bzw. nach der zuvor aufgezeigten Vorschrift subtrahiert, und die Teilsummen anschließend jeweils über ein Verzögerungsglied mit der Verzögerungszeit einer Taktzeit $T = 1/f_A$ verzögert. Die Ausgangssignale der Verzögerungsglieder werden jeweils zu den Teilsummen mit den um L verminderten nächst niedrigeren Indizes addiert, gemäß obigem Beispiel also zunächst $r_{9+z}$ und $q_{9+z}$ und schließlich nach einer nochmaligen Verzögerung $r_{1+z}$ und $q_{1+z}$. Bisher wurde nur der Fall betrachtet, daß die Realteile der Ausgangssignale weiterverwendet wurden (Regellage). Entsprechend können natürlich auch die Imaginärteile der Ausgangssignale ausgewertet werden (Kehrlage).

Anstelle der vorgestellten Lösung mit C8BFI Bandfiltern hätte man auch drei kaskadierte wiederum komplexe Halbbandfilter zur jeweiligen Verdopplung der Abtastfrequenz in drei Stufen verwenden können. Wenn man bei beiden Realisierungsvarianten die Eigenschaft ausnutzen könnte, daß jeweils einige Koeffizienten identisch Null sind, so wären beide Realisierungen etwa gleich aufwendig. Die Kaskadenlösung, die hier nicht weiter betrachtet wird, hat aber den gravierenden Nachteil, daß manche Multiplikationen bei 56 MHz ausgeführt werden müssen, weshalb diese Lösung mit derzeit käuflichen Bauelementen kaum realisierbar sein dürfte.

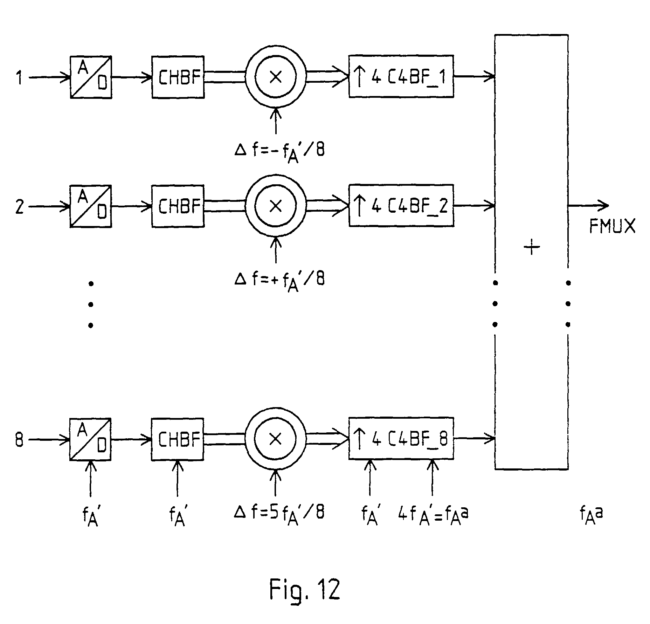

Das bisher vorgestellte Konzept mit einer Anfangsabtastfrequenz von $f_A = 14$ MHz ist relativ aufwendig, sodaß bei der nachfolgend aufgezeigten zweiten Lösungsvariante die Eingangsabtastfrequenz zu $f_A' = 28$ MHz gewählt wird. Das Blockschaltbild zu dieser zweiten Lösungsvariante ist in Figur 12 dargestellt. Es werden hierzu nur jene Baugruppen im einzelnen erläutert, die gegenüber der ersten Lösungsvariante gemäß Figur 1 geändert sind. Es werden wie bei Figur 1 identisch aufgebaute Kanalfilter CHBF verwendet. Die TV-Spektren liegen am Eingang der A/D-Wandler beispielsweise genau so im Frequenzbereich [3,5; 10,5] MHz wie sie später im 7 MHz-Raster liegen sollen. Am Ausgang jedes CHBF Kanalfilters ist dann eine Frequenzverschiebung vorzunehmen und zwar um

$\Delta f = \quad -f_A'/8$ bei den Kanalnummern 1 und 5,
$\Delta f = \quad 3 f_A'/8$ bei den Kanalnummern 3 und 7,
$\Delta f = \quad 5 f_A'/8$ bei den Kanalnummern 4 und 8
$\Delta f = \quad f_A'/8$ bei den Kanalnummern 2 und 6.

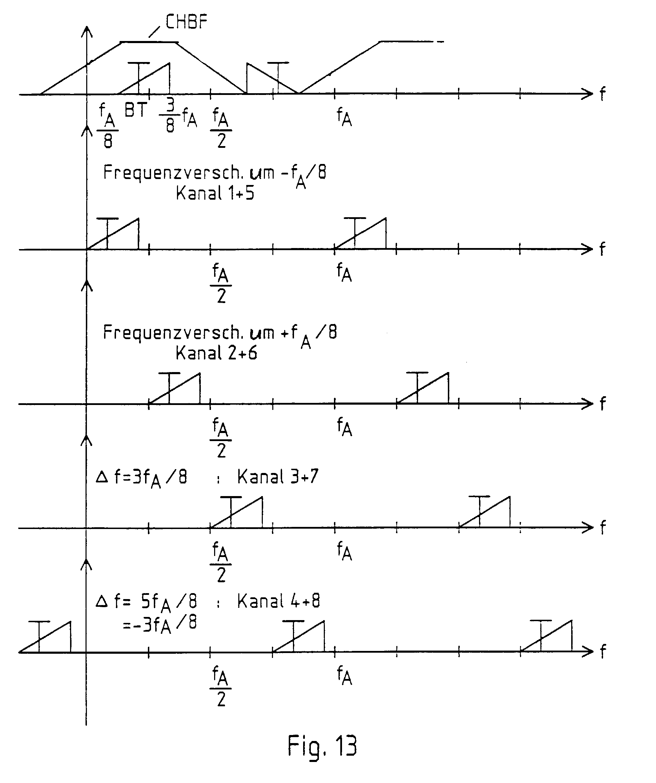

Für andere Kanalraster können diese Frequenzverschiebungen auch anders gewählt werden. Dafür sind lediglich die Trägerfrequenzen siehe Figur (12) zu ändern. Die Bandfilter CnBFI sind hier als kanalindividuelle 4-Bandfilter (n = L = 4) mit komplexen Koeffizienten realisiert gemäß Figur 11, aber nur mit vier anstatt mit acht Zweigen. Die spektrale Darstellung der Aufbereitung der Frequenzmultiplexsignale gemäß der zweiten Variante nach Figur 12 ist in Figur 13 dargestellt. Die erste Zeile von Figur 13 zeigt die Lage der Kanäle mit darüber gezeichneter Filterkennlinie des Kanalfilters CHBF. Die Frequenzverschiebung der Kanäle ist in den folgenden Zeilen der Figur 13 dargestellt:

Kanäle mit den Nummern 1 und 5 - Zeile 2,
Kanäle mit den Nummern 2 und 6 - Zeile 3,
Kanäle mit den Nummern 3 und 7 - Zeile 4,
Kanäle mit den Nummern 4 und 8 - Zeile 5.

Die Kanalfilter CHBF lassen sich z.B. mit folgenden Daten realisieren:

$$f_{d-} = \quad 3,7 \text{ MHz} \left.\right\} \text{ Durchlaßbereiche}$$
$$f_{d+} = 10,3 \text{ MHz}$$
$$f_A' = \quad 28 \text{ MHz}$$
$$f_{sp-} = 17,7 \text{ MHz} \left.\right\}$$
$$f_{sp+} = 24,3 \text{ MHz} \left.\right\} \text{ Sperrbereiche}$$

Koeffizientenzahl $\quad$ N = 11
Sperrdämpfung $\quad$ $a_s \geq 48,5$ dB
Wortbreite $\quad$ $w_s \leq 12$ bit.

Für die 4-Bandfilter C4BFl mit l = 1....8 gelten folgende Dimensionierungsgrundlagen bezogen auf das Prototyp-tiefpaßfilter:

$$f_d = 3,3 \text{ MHz},$$

Sperrbereiche bei

$$m \cdot \frac{f_A^a}{4} \pm 3,3 \text{ MHz}, m = 1,2,3$$

$$f_A^a = 112 \text{ MHz},$$

Sperrdämpfung $a_s \geq 48,5$ dB,
Filterlänge N = 13 Koeffizienten.

Von den N = 13 Koeffizienten ist jeder L-te Koeffizient identisch Null; ausgenommen der mittlere Koeffizient, der gleichzeitig den größten Koeffizientenwert nämlich 1/L = 0,25 aufweist. Bei ± 1 als Aussteuerungsgrenzen liegen also zwei führende Nullen vor, was auch nach der Bildung der komplexen Filterkoeffizienten gilt. Vom Prototypfilter 4BF werden die Kanalfilter C4BFl mit komplexen Koeffizienten abgeleitet, in dem die Impulsantwort des Prototyps auf komplexe Träger der Frequenzen

$$f_c = 1 \cdot 7 \text{ MHz} - 3,5 \text{ MHz} = (1 - \frac{1}{2}) \, 7 \text{ MHz}$$

aufmoduliert wird, wobei l = 1...8 wiederum die Kanalnummer angibt.

Für die Filter-Realisierungen gelten die den Figuren 7 bis 11 zugrunde liegenden Überlegungen. Dabei sind von den maximal möglichen 2N = 26 Koeffizienten der C4BFl-Bandfilter jeweils 5 identisch Null, also jeweils nur 21 Multiplikationen bei $f_A$ = 28 MHz auszuführen, falls die Symmetrie der Koeffizienten nicht ausgenutzt wird. Am Ausgang der CHBF-Kanalfilter ist jeweils eine Kanalindividuelle Frequenzverschiebung vorzunehmen (vgl. Figuren 12 und 13). Es handelt sich um die einfach zu erzeugenden Trägerfrequenzen

$$-f_A'/8 \triangleq \frac{7}{8} f_A', \, \frac{f_A'}{8}, \, \frac{3f_A'}{8}, \, \frac{5f_A'}{8},$$

Allgemein gilt:

$$f_c = (2n - 1) \frac{f_A'}{8}; \, n = 1, 2, 3, 4.$$

Diese Trägerfrequenzen können alle aus einem gleichen ROM ausgelesen werden. Dort sind 8 Abtastwerte der Frequenz $f_A'/8$ ($f_A'$= 28 MHz) abzulegen, wobei für die Trägerfrequenz $f_C$ = (2n -1) $f_A'/8$ jeweils jeder (2n-1)te Eintrag zyklisch auszulesen ist. Von der komplexen Trägerschwingung

$$s_C(kT) = e^{j2\pi kfe/f_A'} = e^{j2\pi k\frac{2n-1}{8}} =$$

$$= \cos\left[k\frac{\pi}{4}(2n-1)\right] + j\sin\left[k\frac{\pi}{4}(2n-1)\right]$$

$$k: \text{ Zeitindex}; \qquad n: \text{ Frequenzindex}$$

sind jeweils Real- und Imaginärteil bereitzustellen.

Obwohl die zu verarbeitenden 8 Einzelkanalsignale nichtkohärent/nichtsynchron sind, werden sie synchron abgetastet und verarbeitet. Deshalb können die Addierer der verteilten Summenbildung Figur 1:ADD) ebenso wie bei den Polyphasen-Netzwerken über die Ausgangsmultiplexer nach vorn zu tieferen Frequenzen gezogen werden.

Bisher wurde nur die Zusammenfassung von Einzelkanalsignalen durch Frequenz Frequenz-Multiplexbildung betrachtet. Durch Hermite'sche Transposition gemäß [5] lassen sich für die Zerlegung eines Frequenzmultiplexsignals entsprechende Strukturen und Realisierungen verwirklichen. Für die Zerlegung hier nur die grundsätzlichen Verfahrensschritte:

- Abtastratenwandlung der Teilbänder mittels eines komplexen Polyphasen-Fitternetzwerkes durch Dezimation um den Faktor L,
- Frequenzverschiebung der abtastratengewandelten Teilbänder so, daß ihre Spektren die gleiche Frequenzlage einnehmen,
- Vorfilterung der so behandelten Signale für eine sich anschließende D/A-Wandlung.

Zitatliste:

[1] IEEE Transactions on Communications, Vol. COM-30, No.7, Juli 1982, Seiten 1623 - 1628,
[2] DE 37 16 018 C1,
[3] DE 37 05 207 C2,
[4] IEEE Transactions on Acoustics, Speech, and Signal Processing, Vol. ASSP-30, No. 5, October 1982, Seiten 734 - 738 (Mintzer),
[5] Philips J. Res. Vol., 33, Nos. 1/2, 1978, Seiten 78 - 102,
[6] Advanced Topics in Signal Processing, J.S.Lim, A.V.Oppenheim, Prentice Hall, New Jersey, Seiten 148 - 155, insbesondere Figur 3.21.

**Patentansprüche**

1. Verfahren zur Aufbereitung eines digitalen FrequenzmultiplexSignals aus Kanalsignalen unter Anwendung folgender Schritte:

   - die Kanalsignale werden jeweils einzeln mit einer Abtastfrequenz $f_A$ abgetastet und digitalisiert,

   - die digitalisierten Kanalsignale werden nachgefiltert mit gleichartig aufgebauten Digitalfiltern mit komplexen Koeffizienten zur Erzeugung komplexwertiger Ausgangssignale, gekennzeichnet durch folgende Schritte:

   - die so behandelten Kanalsignal werden gegeneinander derart frequenzverschoben,daß sich die Spektren benachbarter Kanalsignale nicht überlappen,

   - die komplexwertigen frequenzverschobenen Kanalsignale werden jeweils mittels eines Polyphasen-Filternetzwerkes mit komplexen Koeffizienten einer Abtastratenwandlung durch Interpolation um den Faktor L unterzogen,

   - die abtastratengewandelten Kanalsignale werden mittels eines Multiplexers, der mit der Abtastrate $f_A * L$ betrieben wird, zu einem Frequenzmultiplex-Gesamtsignal ineinander verschachtelt.

2. Verfahren nach Anspruch 1, dadurch gekennzeichnet, daß zur Frequenzverschiebung die Kanal signale mit geraden Nummern um die Hälfte der Abtastfrequenz ($f_A/2$) bei der Digitalisierung verschoben werden.

3. Verfahren nach Anspruch 1, dadurch gekennzeichnet, daß zur Frequenzverschiebung je zwei Kanalsignale mit der Trägerfrequenz $f_c = (2n - 1) \cdot f_A/N$ umgesetzt werden, wobei $n = 1,2,....N/2$ und N die Anzahl der einzelnen Kanalsignale bedeutet.

4. Verfahren nach Anspruch 1 oder 2, dadurch gekennzeichnet, daß die analogen Kanalsignale zur Digitalisierung mit jeweils einer Mittenfrequenz von $f_A/4$ angeliefert werden.

5. Verfahren nach einem der Ansprüche 1 bis 4, dadurch gekennzeichnet, daß die Polyphasen-Filternetzwerke durch

7

FIR-Filter realisiert sind.

6. Verfahren nach Anspruch 5, dadurch gekennzeichnet, daß einige Koeffizienten entsprechend den Dämpfungserfordernissen zu Null gewählt werden.

7. Verfahren nach Anspruch 6, dadurch gekennzeichnet, daß das Polyphasen-Filternetzwerk in Form eines L-Bandfilters aufgebaut wird.

8. Verfahren nach einem der Ansprüche 1 bis 7, dadurch gekennzeichnet, daß bei Verwendung eines L-Band-Prototyp-Tiefpaßfilters für die Abtastratenwandlung durch geeignete Wahl der Nullphase der komplexen Trägerschwingung für die Frequenzverschiebung mindestens ein nichtverschwindender komplexer Koeffizient entsteht, der rein reell oder rein imaginär ist.

9. Verfahren nach Anspruch 8, dadurch gekennzeichnet, daß das L-Band Filter so bemessen wird, daß der mittlere Filterkoeffizient - Symmetriezentrum bei linearphasigen L-Band-Filtern - als nichtverschwindender rein reeller oder rein imaginärer Koeffizient erscheint.

10. Verfahren nach einem der Ansprüche 1 bis 9, dadurch gekennzeichnet, daß das Polyphasen-Filternetzwerk mit komplexen Koeffizienten aus L komplexen Zweigfiltern aufgebaut wird, daß jeweils in den L-Zweigen die Faltungen von Realteil und Imaginärteil des komplexwertigen frequenzverschobenen Kanalsignals $\underline{s} = s_r + js_i$ mit den komplexen Zweigfilterimpulsantworten $\underline{c}_z = r_z + jq_z$ des betreffenden Zweiges z, mit z = 0,...L-1, wie folgt zusammengefaßt werden:

$$y_{rz} = s_r * r_z - s_i * q_z$$

und daß anschließend alle L Realteile $y_{rz}$ kanalweise zu $y_r$ gemultiplext werden.

11. Verfahren nach Anspruch 10 unter Verwendung von nicht rekursiven Zweigfilter-Strukturen, dadurch gekennzeichnet, daß die einzelnen Multiplikationen in den L Zweigen mit den Koeffizienten

$$q_{L \cdot M + z + 1} \text{ und } r_{L \cdot + z + 1}$$

vorgenommen werden, wobei
M = 0, 1, 2 .... und
z = 0.....L - 1 ist,
daß für den Realteil $y_{rz}$ die Teil-Produkt-Paare mit jeweils gleichen Indizes addiert werden und daß die Teilsummen anschließend jeweils über ein Verzögerungsglied mit der Verzögerungszeit einer Taktzeit $T = 1/f_A$ verzögert werden und die Ausgangssignale der Verzögerungsglieder jeweils zu den Teilsummen mit den um L verminderten nächst niedrigeren Indizes addiert werden und diese Operationen gegebenenfalls entsprechend wiederholt werden.

12. Verfahren nach Anspruch 10, dadurch gekennzeichnet, daß alle Kanalsignale über nur ein Polyphasen-Filternetzwerk mit komplexen Koeffizienten geführt werden, daß die einzelnen Multiplikationen für die jeweils L Zweige mit den Koeffizienten

$$q_{L \cdot M + z + 1} \text{ und } r_{L \cdot M + z + 1}$$

vorgenommen werden, wobei
M = 0, 1, 2,.... und z = 0....L-1 ist,
daß für den Realteil $y_{rz}$ alle L Teilprodukt-Paare mit jeweils gleichen Indizes addiert werden, und daß die Teilsummen anschließend jeweils über ein Verzögerungsglied mit der Verzögerungszeit einer Taktzeit T verzögert werden und die Ausgangssignale der Verzögerungsglieder jeweils zu den Teilsummen mit den um L verminderten nächst niedrigeren Indizes addiert werden und diese Operationen gegebenenfalls entsprechend wiederholt werden.

13. Verfahren nach Anspruch 10, 11 oder 12, dadurch gekennzeichnet, daß anstelle der Realteile $y_{rz}$ bzw. $y_r$ die entsprechenden Operationen für die Imaginärteile $y_{iz}$ bzw. $y_i$ durchgeführt werden.

8

**14.** Verfahren zur Zerlegung eines Frequenzmultiplexsignals in Kanalsignale unter Anwendung folgender Schritte:

- das Frequenzmultiplexsignal wird mittels eines Demultiplexers in Teilbänder zerlegt, die Teilbänder werden mittels eines Polyphasen-Filternetzwerkes mit komplexen Koeffizienten einer Abtastratenwandlung durch Dezimation um den Faktor L unterzogen,

- die abtastratengewandelten Teilbänder werden zu Kanalsignalen verarbeitet indem die Teilbänder gegeneinander frequenzverschoben werden derart, daß ihre Spektren die gleiche Frequenzlage einnehmen,

- die Kanalsignale werden zur Vermeidung spektraler Überfaltungen nachgefiltert und gegebenenfalls einer Digital-Analogwandlung unterzogen.

**15.** Verfahren nach Anspruch 14 unter Anwendung der Schritte von einem der Ansprüche 2 bis 13 in entsprechend abgewandelter Form für die Zerlegung des Frequenzmultiplexsignals.

**Claims**

**1.** Method for conditioning a digital frequency multiplexed signal from channel signals, using the following steps:

- the channel signals are respectively sampled individually at a sampling frequency $f_A$ and digitized,
- the digitized channel signals are subsequently filtered using digital filters of similar design and having complex coefficients, for the purpose of generating complex-valued output signals, characterized by the following steps:
- the signal channels thus treated are frequency-shifted with respect to one another in such a way that the spectra of neighbouring channel signals do not overlap,
- the complex-valued frequency-shifted channel signals are in each case subjected by means of a polyphase filter network with complex coefficients to a sampling rate conversion by the factor L by interpolation,
- the channel signals with a converted sampling rate are mutually interleaved to form a total frequency multiplexed signal by means of a multiplexer which is operated at the sampling rate $f_A * L$.

**2.** Method according to Claim 1, characterized in that, for the purpose of frequency shifting, the channel signals with even numbers are shifted during the digitization by half the sampling frequency ($f_A/2$).

**3.** Method according to Claim 1, characterized in that, for the purpose of frequency shifting, two channel signals each are converted using the carrier frequency $f_c = (2n - 1) \cdot f_A/N$, it being the case that n = 1,2,...N/2 and N signifies the number of the individual channel signals.

**4.** Method according to Claim 1 or 2, characterized in that the analog channel signals are supplied for the purpose of digitization with a centre frequency of $f_A/4$ in each case.

**5.** Method according to one of Claims 1 to 4, characterized in that the polyphase filter networks are implemented by FIR filters.

**6.** Method according to Claim 5, characterized in that some coefficients are selected to be zero in accordance with the damping requirements.

**7.** Method according to Claim 6, characterized in that the polyphase filter network is constructed in the form of an L-band filter.

**8.** Method according to one of Claims 1 to 7, characterized in that, in the case of using an L-band prototype low-pass filter for the sampling rate conversion, suitable selection of the zero phase of the complex carrier for the frequency shift produces at least one non-vanishing complex coefficient, which is purely real or purely imaginary.

**9.** Method according to Claim 8, characterized in that the L-band filter is dimensioned such that the average filter coefficient - centre of symmetry in the case of linear-phase L-band filters - appears as a non-vanishing purely real or purely imaginary coefficient.

**10.** Method according to one of Claims 1 to 9, characterized in that the polyphase filter network with complex coefficients is constructed from L complex branch filters, in that the convolutions of real part and imaginary part of the complex-valued frequency-shifted channel signal $\underline{s} = s_r + js_i$ with the complex branch filter impulse responses $\underline{c}_z = r_z + jq_z$ of the relevant branch z, where z = 0,...L - 1, are combined as follows in each case in the L-branches:

$$y_{rz} = s_r * r_z - s_i * q_z$$

and in that subsequently all L real parts $y_{rz}$ are multiplexed by channel to form $y_r$.

11. Method according to Claim 10 using non-recursive branch filter structures, characterized in that the individual multiplications in the L branches are performed using the coefficients

$$q_L \cdot M + z + 1 \text{ and } r_L \cdot M + z + 1,$$

it being the case that
M = 0, 1, 2, ... and
z = 0...L - 1,
in that the partial product pairs having respectively identical indices are added for the real part $y_{rz}$, and in that the partial sums are subsequently delayed in each case via a time-delay element with the time delay of a clock pulse period $T = 1/f_A$, and the output signals of the time-delay elements are added in each case to the partial sums with the next-lower indices reduced by L, and these operations are correspondingly repeated if appropriate.

12. Method according to Claim 10, characterized in that all the channel signals are routed via only one polyphase filter network with complex coefficients, in that the individual multiplications for the respectively L branches are performed using the coefficients

$$q_L \cdot M + z + 1 \text{ and } r_L \cdot M + z + 1,$$

it being the case that
M = 0, 1, 2, ... and z = 0...L - 1,
in that all L partial product pairs having respectively identical indices are added for the real part $y_{rz}$, and in that the partial sums are subsequently delayed in each case via a time-delay element with the time delay of a clock pulse period $T = 1/f_A$, and the output signals of the time-delay elements are added in each case to the partial sums with the next-lower indices reduced by L, and these operations are correspondingly repeated if appropriate.

13. Method according to Claim 10, 11 or 12, characterized in that instead of the real parts $y_{rz}$ or $y_r$ the corresponding operations are carried out for the imaginary parts $y_{iz}$ or $y_i$.

14. Method for decomposing a frequency multiplexed signal into channel signals, using the following steps:

- the frequency multiplexed signal is decomposed into sub-bands by means of a demultiplexer, the sub-bands are subjected by means of a polyphase filter network with complex coefficients to a sampling rate conversion by the factor L by decimation,
- the sub-bands with a converted sampling rate are processed to form channel signals by frequency-shifting the sub-bands with respect to one another in such a way that their spectra assume the same frequency position, and
- the channel signals are subsequently filtered to prevent overconvolutions and are subjected to digital-to-analog conversion if appropriate.

15. Method according to Claim 14 using the steps of one of Claims 2 to 13 in an appropriately modified form for decomposing the frequency multiplexed signal.

**Revendications**

1. Procédé de traitement d'un signal numérique multiplexé en fréquence à partir de signaux de canaux, mettant en oeuvre les étapes suivantes :

- les signaux de canaux sont détectés séparément selon une fréquence de détection $f_A$ et sont numérisés,
- les signaux de canaux, numérisés, sont alors filtrés avec des filtres numériques de même type de construction, à coefficients complexes, pour générer des signaux de sortie complexes,

procédé caractérisé par les étapes suivantes :

- les signaux de canaux ainsi traités sont décalés en fréquence les uns à la suite des autres pour que les spectres de signaux de canaux voisins ne se chevauchent pas,
- les signaux de canaux complexes, décalés en fréquence, sont soumis chaque fois par un réseau de filtres polyphasés à coefficients complexes à une conversion de vitesse de détection par interpolation selon le coefficient L,
- les signaux de canal à vitesse de détection convertie, sont imbriqués à l'aide d'un multiplexeur fonctionnant à une vitesse de détection $f_A * L$ pour donner un signal global multiplexé en fréquence.

2. Procédé selon la revendication 1,
   caractérisé en ce que
   pour le décalage en fréquence, les signaux de canal de nombre pair sont décalés de la moitié de la fréquence de détection ($f_A/2$) à la numérisation.

3. Procédé selon la revendication 1,
   caractérisé en ce que
   pour le décalage en fréquence, chaque fois deux signaux de canal sont convertis avec une fréquence porteuse $f_c = (2n - 1) \cdot f_A/N$, relation dans laquelle $n = 1,2,...N/2$ et N est le nombre des différents signaux de canal.

4. Procédé selon la revendication 1 ou 2,
   caractérisé en ce que
   les signaux de canal analogique sont fournis pour la numérisation avec chaque fois une fréquence moyenne de $f_A/4$.

5. Procédé selon l'une des revendications 1 à 4,
   caractérisé en ce que
   les réseaux de filtres polyphasés sont des filtres FIR.

6. Procédé selon la revendication 5,
   caractérisé en ce que
   certains coefficients sont choisis égaux à zéro pour satisfaire à des conditions d'amortissement.

7. Procédé selon la revendication 6,
   caractérisé en ce que
   le réseau de filtres polyphasés est construit sous la forme d'un filtre passe-bande L.

8. Procédé selon l'une des revendications 1 à 7,
   caractérisé en ce que
   par l'utilisation d'un filtre passe-bande prototype à bande L pour la conversion de vitesse de détection, par un choix approprié de la phase zéro de l'oscillation de la porteuse complexe pour le décalage en fréquence, on a au moins un coefficient complexe non évanescent, qui est purement réel ou purement imaginaire.

9. Procédé selon la revendication 8,
   caractérisé en ce que
   le filtre passe-bande L est dimensionné pour que le coefficient de filtre moyen (sonde de symétrie pour des filtres passe-bande L à phase linéaire) n'apparaisse pas comme un coefficient non évanescent purement réel ou purement imaginaire.

10. Procédé selon l'une des revendications 1 à 9,
    caractérisé en ce que
    le réseau de filtres polyphasés est construit avec des coefficients complexes de L filtres d'embranchement complexes, et chaque fois dans les embranchements L, on effectue la convolution de la partie réelle et de la partie imaginaire du signal de canal complexe, décalé en fréquence, $\underline{s} = s_r + js_i$, avec des réponses impulsionnelles complexes de filtres d'embranchement $\underline{c}_z = r_z + jq_z$ de la branche z correspondante, avec $z = 0...L-1$, en combinant comme suit :

$$y_{rz} = s_r * r_z - s_i * q_z,$$

puis on multiplexe toute partie L réelle $y_{rz}$ par canal pour former $y_r$.

11. Procédé selon la revendication 10, utilisant des structures de filtres d'embranchement non récurrentes, caractérisé en ce que
les différentes multiplications sont effectuées dans les L branches avec les coefficients :

$$^q L . M + z + 1 \text{ et } ^r L . M + z + 1,$$

avec,
$M = 0, 1, 2 ..... $ et,
$z = 0...... L - 1,$
et, pour la partie réelle $y_{rz}$, on additionne les paires de produits partiels chaque fois de même indice, et en ce que les sommes partielles sont alors retardées chaque fois par un élément de temporisation, d'une temporisation d'une période exacte $T = 1/f_A$, et les signaux de sortie des élément de temporisation sont chaque fois additionnés aux sommes partielles d'indice plus bas suivant, diminué de L, et on répète le cas échéant ces opérations.

12. Procédé selon la revendication 10,
caractérisé en ce que
tous les signaux de canal sont appliqués par un réseau de filtres polyphasés à coefficients complexes, les différentes multiplications pour chacune des L branches avec les coefficients :

$$^q L . M + z + 1 \text{ et } ^r L . M + z + 1,$$

avec $M = 0, 1, 2, ..... $ et, $z = 0......L-1,$
et pour la partie réelle $y_{rz}$, on additionne toutes les L paires de produits partiels chaque fois de même indice et on retarde les sommes partielles chaque fois par un élément de temporisation d'une temporisation d'une période T, et les signaux de sortie des éléments de temporisation sont additionné chaque fois aux sommes partielles d'indice plus bas suivant, diminué de L, et on répète le cas échéant ces opérations.

13. Procédé selon la revendication 10, 11 ou 12,
caractérisé en ce que
à la place des parties réelles $y_{rz}$ ou $y_r$, on effectue les opérations correspondantes pour les parties imaginaires $y_{iz}$ ou $y_i$.

14. Procédé de décomposition d'un signal multiplexé en fréquence en des signaux de canaux, mettant en oeuvre les étapes suivantes :

- le signal multiplexé en fréquence est décomposé, par un démultiplexeur, en des bandes partielles, ces bandes partielles sont soumises, par un réseau de filtres polyphasés à coefficients complexes, à une conversion de vitesse de détection par décimation du coefficient L,
- les bandes partielles converties en fréquence de détection, sont traitées pour donner des signaux de canaux, en ce que les bandes partielles sont relevées en fréquence les unes par rapport aux autres pour que les spectres prennent la même position de fréquence,
- les signaux de canal, pour éviter le chevauchement des spectres, sont filtrés et sont soumis le cas échéant à une conversion numérique/analogique.

15. Procédé selon la revendication 14, appliquant les étapes de l'une quelconque des revendications 2 à 13, sous une forme modifiée, de façon appropriée, pour décomposer le signal multiplexé en fréquence.

Fig. 1

Fig. 3

CHBF

$f_A$    $2f_A$    $3f_A$    $4f_A$    $8f_A$
= $f_A{}^a$

Eingang der C8BF_l mit l ungerade, C8BF_l

C8BF 1    C8BF 5

$f_A$    $2f_A$    $3f_A$    $4f_A = \dfrac{f_A{}^a}{2}$    $6f_A$    $8f_A$
= $f_A{}^a$

Eingang der C8BF_l mit l gerade, C8BF_l

C8BF 2    C8BF 8

$f_A$    $2f_A$    $3f_A$    $4f_A = \dfrac{f_A{}^a}{2}$  $5f_A$    $6f_A$    $8f_A$
= $f_A{}^a$

Reelle Ausgangssignale der C8BF l

(l=5)
(l=8)

$2f_A$    $\dfrac{f_A{}^a}{2}$    $6f_A$    $f_A{}^a$

Summensignal
Spektrum    Spiegelfrequenzen

l=1  2  3  4  5  6  7  8  $\dfrac{f_A{}^a}{2}$  8  7  6  5  4  3  2  1  $\dfrac{f_A{}^a}{2}$  1

Fig. 2

14

$$-|h_5| \qquad -|h_3| \qquad -|h_1| \qquad |h_1| \qquad |h_3| \qquad |h_5|$$

Re

2T ⊕ 2T ⊕ 2T ⊕ 2T ⊕ 2T ⊕

$$\frac{N-1}{2}\,T \qquad ho=\frac{1}{2}$$

Jm

Fig. 4

Re
Sr

↑8 C8BF — r

↑8 C8BF — q

$f_A$

↑8 C8BF — q

↑8 C8BF — r

$f_A^a$

Jm
Si

Yr → Re (Regellage)

Yi → Jm (Kehrlage)

Fig. 7

15

Fig. 5

Fig. 6

17

Fig. 8

Fig. 9

Fig. 11

Fig. 10

Fig. 12

Fig. 13